# EUROPEAN PATENT APPLICATION

(11) **EP 0 531 571 A1**
(43) Date of publication of application: **17.03.1993**
(21) Application number: 91115488.8
(22) Date of filing: 12.09.1991
(51) Int. Cl.: C25D 17/06

(54) **An automatic loading mechanism for PC board electroplating**

(71) Applicant: Kuo, Ming-Hong, Taipei (TW)
(72) Inventor: Kuo, Ming-Hong, Taipei (TW)
(74) Representative: Kador & Partner

(57) **Abstract**

This invention relates to an automatic loading mechanism for PC board electroplating and in particular to one utilizing a program controlling device to activate pneumatic cylinders (22) to open a clamp (21) and move a supporting frame together with a fly bar (7) and clamping devices downwards until the PC boards (6) are guided by bell-shaped entrance of guiding devices and cover the sensor, then withdraw the pneumatic cylinders causing the clamps to grip the PC boards and raise the supporting frame to its original position thereby achieving the purpose of automatic loading.

## Description

### BACKGROUND OF THE BACKGROUND

It is found that the presently used loading method for PC board electroplating is simply achieved by means of manual power. Hence, a lot of man power is required for the operation thereby increasing the cost and decreasing the production rate.

Therefore, it is an object of the present invention to provide an automatic loading mechanism for PC board electroplating which may obviate and mitigate the above-mentioned drawbacks.

### SUMMARY OF THE INVENTION

This invention relates to an automatic loading mechanism for PC board electroplating.

It is the primary object of the present invention to provide an automatic loading mechanism for PC board electroplating which utilizes a program controlling device to control a clamping device to accurately grip PC boards on a PC board insertion device so that an elevating device will move together with the fly bar and the clamping device to an electroplating trough.

It is another object of the present invention to provide an automatic loading mechanism for PC board electroplating which utilizes a guiding device with a bell-shaped entrance to guide PC boards thereby enabling the clamping device to grip the PC boards accurately.

It is still another object of the present invention to provide an automatic loading mechanism for PC board electroplating which makes use photo sensors to control the lowering distance of the clamping device so as to adapt to PC boards with various sizes.

It is still another object of the present invention to provide an automatic loading mechanism for PC board electroplating which may increase the efficiency and save a lot of labor.

It is a further object of the present invention to provide an automatic loading mechanism for PC board electroplating which may be mounted on any kind of electroplating production line.

Other objects and merits and a fuller understanding of the present invention will be obtained by those having ordinary skill in the art when the following detailed description of the preferred embodiment is read in conjunction with the accompanying drawings.

### BRIEF DESCRIPTION OF THE DRAWINGS

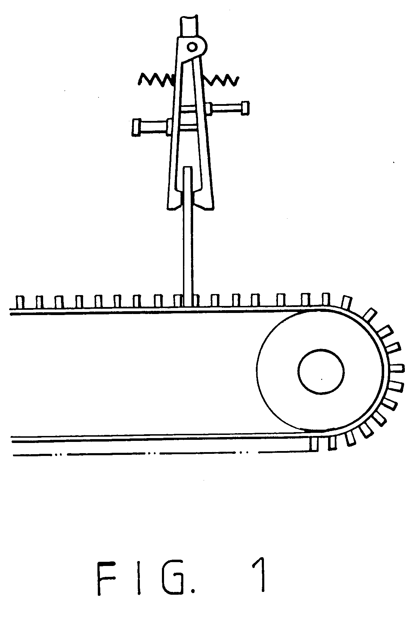

FIG. 1 is a schematic view showing the prior art loading operation of the PC board electroplating;
FIG. 2 shows the structure of an automatic loading mechanism for PC board electroplating according to the present invention;

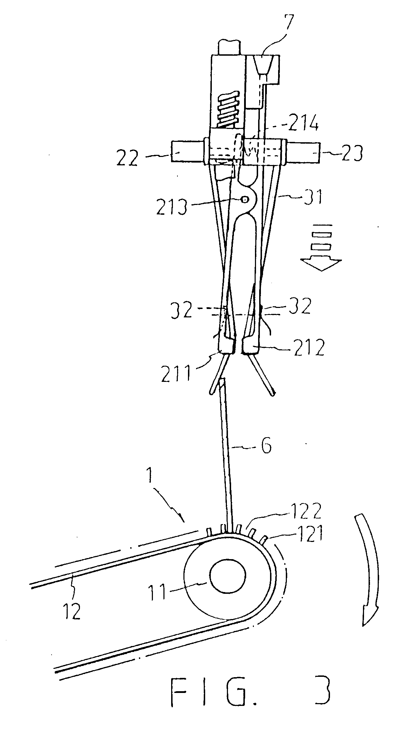

FIG. 3 is a front view of the automatic loading mechanism for PC board electroplating;

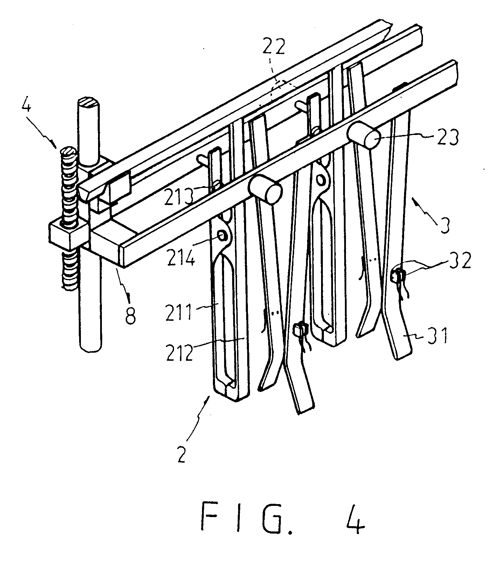

FIG. 4 is an enlarged fragmentary view of FIG. 2; and

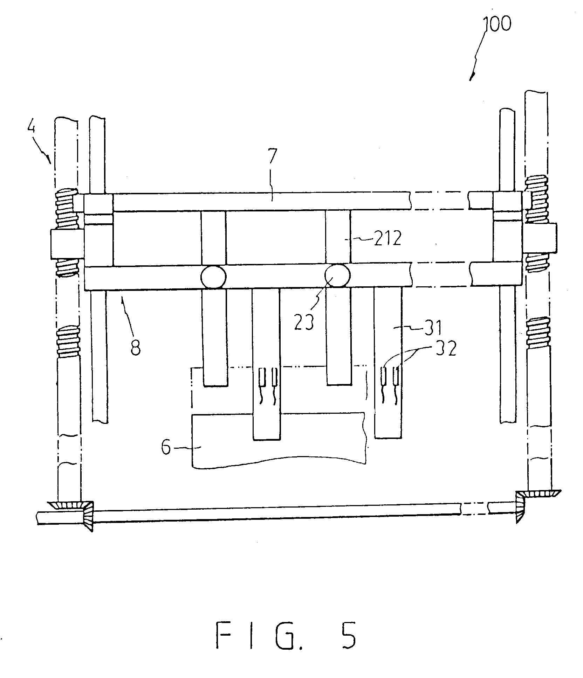

FIG. 5 is a side elevational view of the automatic loading mechanism PC board electroplating.

### DETAILED DESCRIPTION OF THE PREFERRED EMBODIMENT

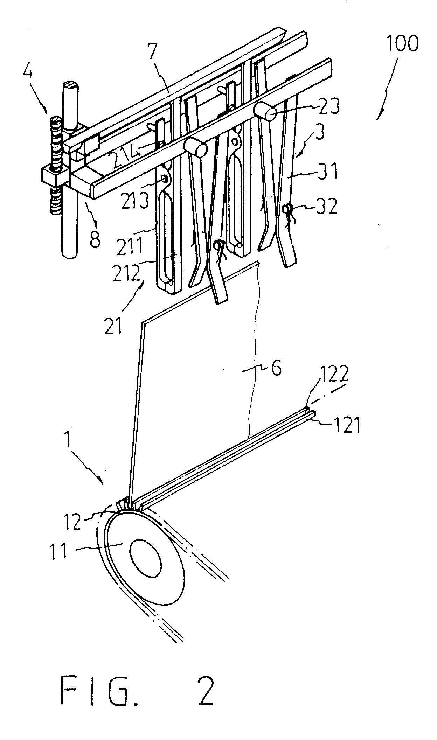

With reference to the drawings and in particular to FIG. 2 thereof, the automatic loading mechanism 100 for PC board electroplating according to the present invention mainly comprises a PC board insertion device 1, a plurality of clamping devices 2, a plurality of guiding devices 3, a vertical sliding device 4 and a program controlling device (not shown).

The PC board insertion device 1 is mounted on the lower portion of the present invention and is constituted by two cylindrical members 11, a circulating belt 12 and a motor (not shown). The two cylindrical members 11 are arranged at opposite positions and wrapped around by the circulating belt 12. On the circulating belt 12 there are a plurality of parallel flaps 121 thereby forming a plurality of grooves 122 for receiving PC boards to be electroplated. The linking mechanism between the motor 13 and the cylinderical member 11 and the connection between the cylindrical member 11 and the circulating belt 12 are well known in the art and have no need to be described here in detail. The PC board insertion device 1 is characterized in its angular arrangement which will provide a peak point at both adjacent sides of which the grooves will incline outward with respect to the groove at the peak point hence preventing the PC board at the peak point to be clamped from being disturbed by the PC boards at both adjacent sides.

The clamping device 2 is disposed at the upper part of the present invention and composed of a clamp 21 and two pneumatic cylinders 22. The clamp 21 comprises a front arm 211 and a rear arm 212 pivoted approximately at the intermediate position thereof. A spring 214 is mounted between the front arm 211 and the rear arm 212 and located above the pivot 213 of the front arm 211 and the rear arm 212 so as to force the clamp 21 to keep closed normally. The clamp 21 is connected with a power supply (not shown) so that electrical current may pass therethrough for electroplating. The upper end of the rear arm 212 is fixedly connected with a fly bar 7 which may be elevated and moved by a sliding frame (not shown) to an electroplating trough (not shown) and so the PC board held by the clamp 21 may be lowered into the electroplating trough. Further, the clamp 21 is arranged within a supporting frame 8 on which there are two pneumatic cylinders 22 and 23 for pushing the front arm 211 and rear arm 212 respectively. When the pneumatic cylinders 22 and 23 are activated, the pneumatic cylinders 22 and 23 will push against the upper part of the rear arm 212 and the front arm 211 thereby opening the clamp 21 for gripping or releasing a PC board. As the pneumatic cylinders 22 and 23 return to their orginal positions, the spring 214 will push the clamp 21 to close again. It is preferred to mount the pneumatic cylinders above the spring 214 so as to reduce the force required to open the clamp 21 and therefore, decreasing the load of the pneumatic cylinders.

The guiding device 3, which is designed to guide the movement of the PC board such that the clamp 21 may accurately grip the PC board 6, is composed of two strips 31 and two photo sensors 32. The upper parts of the two strips 31 are fixedly mounted on the supporting frame 8, while the lower parts thereof are bent into a bell-shaped entrance. Hence, even if the PC board 6 inclines towards either side, the PC board 6 may still go into the entrance of the guiding device 3 and guided to an upright position by the bell-shaped entrance so as to adapt to the operation of the clamp 21. The photo sensors 32 are connected to the program controlling device 5 and located above the gripping point of the clamp 21 for controlling the movement of the supporting frame 8 and the clamping device 2 so that the clamping device 2 may grip PC boards with various sizes. When in use, the supporting frame 8 is first lowered with the clamping device 2 (the clamping device is opened at that time), the bell-shaped entrance of the guiding device 3 will guide the PC board 6 to an appropriate position. As the supporting frame is further lowered together with the clamping device 2 until the photo sensor 32 on the guiding device 3 is covered by the upper portion of the PC board 6, the photo-sensors 32 will send out a signal to the program controlling device 5, which will stop the supporting frame 8 from further moving downwards and withdraw the pneumatic cylinders 22 and 23. Hence, the clamping device 2 will grip PC boards 6 with various sizes.

The vertical sliding device 4 is mounted at both sides of the supporting frame 8 and utilizes a motor to drive lead screws in association with nuts to move the supporting frame 8 upwards and downwards. Also, the lead screws and the nuts may be replaced with chains and sprockets. However, the vertical sliding device 4 is well known in the art and has no need to be described here in detail.

The program controlling device 5 is designed to control PC board insertion device 1, the clamping device 2, the guiding device 3 and the vertical sliding device 4 to work in accordance with the preset order. When the in use, first insert PC boards in the grooves 122 of the PC board insertion device 1 and turn on the present invention. In the meantime, the program controlling device 5 will activate the pneumatic cylinders 22 and 23 thereby opening the clamp 21. Then, the supporting frame 8 together with the fly bar 7 and the clamping device 2 will be moved downwards until the PC board 6 is guided by the bell-shaped entrance of the guiding device 3. As the photo sensor 32 is covered by the PC board 6, the pneumatic cylinders 22 and 23 will be withdrawn to their original positions and the clamp 2 will grip the PC board 6 by means of the spring 214. Thereafter, the supporting frame 8 will return to its original position and the circulating belt 12 of the PC board insertion device 1 will automatically move forwards thus moving another PC board 6 to the position against the clamp 21 and begining another working cycle. Then, an elevating device (not shown) on the electroplating production line will move the fly bar 7 together with the clamp 21 and the PC boards 6 to an electroplating trough (not shown); however, such means is well known in the art and will not be mentioned here in detail.

Although the present invention has been described with a certain degree of particularity, it is understood that the present disclosure is made by way of example only and that numerous changes in the construction and the combination and arrangement of parts may be resorted to without departing from the spirit and scope of the invention as hereinafter claimed.

## Claims

1. An automatic loading mechanism for PC board electroplating comprises:
a PC board insertion device for receiving PC boards;
a supporting frame on which is mounted a fly bar; a vertically sliding device engaged with said supporting frame and being able to move upwards and downwards;
a plurality of clamping devices mounted on said supporting frame;
a plurality of guiding devices fixedly connected at the upper end with said supporting frame and having a bell-shaped entrance at the lower end, said guiding device being provided with photo sensors; and
a program controlling device for controlling working order of aforesaid devices;
whereby when in use, said program controlling device first activates pneumatic cylinders to open said clamping devices and then said supporting frame together with said fly bar and said said clamping devices is moved downwards until the PC board on said PC board insertion device goes into said guiding device through the bell-shaped entrance thereof and covers the photo sensor, and thereafter said pneumatic cylinders withdraw to original positions and said clamping devices grip said PC boards and said fly bar returns to original position.

2. The automatic loading mechanism for PC board electroplating as claimed in Claim 1, wherein said PC board insertion device is disposed angularly on lower portion of said mechanism and utilizes a circulating belt to wrap around rollers and a motor to drive said rollers to move said circulating belt thereby automatically feeding the PC boards on said circulating belt.

3. The automatic loading mechanism for PC board electroplating as claimed in Claim 1, wherein said clamping device comprises a clamp and two pneumatic cylinders, said clamp having a front arm and a rear arm pivotally connected together and a spring mounted between said front arm and said rear arm and located above the pivot for keeping said clamp closed normally, said rear arm being fixedly connected with said fly bar at a top end so that an elevating device may move said fly bar together with said clamp and said PC boards to an electroplating trough.

4. The automatic loading mechanism for PC board electroplating as claimed in Claim 1, wherein said vertically sliding device utilizes lead screws in association with nuts to move said supporting frames upwards and downwards.

5. The automatic loading mechanism for PC board electroplating as claimed in Claim 1, wherein said vertically sliding device utilizes chains in association with sprockets to move said supporting frames upwards and downwards.
